# EUROPÄISCHE PATENTSCHRIFT

(11) **EP 1 782 079 B1**
(45) Veröffentlichungstag und Bekanntmachung des Hinweises auf die Patenterteilung: **10.12.2008**
(21) Anmeldenummer: 05771469.3
(22) Anmeldetag: 26.07.2005
(51) Int. Cl.: G01R 35/00, H01R 13/646

(54) **KALIBRIERSTANDARD**
CALIBRATION STANDARD
TALON DE CALIBRAGE

(30) Priorität: 25.08.2004 DE 20413305 U
(43) Veröffentlichungstag der Anmeldung: 09.05.2007
(73) Patentinhaber: Rosenberger Hochfrequenztechnik GmbH & Co. KG, 83413 Fridolfing (DE)
(72) Erfinder: WEISS, Frank, 02994 Bernsdorf (DE); OPPELT, Reiner, 83404 Ainring (DE); NESTLER, Gerhard, 84329 Wurmannsquick (DE)
(74) Vertreter: Kandlbinder, Markus Christian
(86) Internationale Anmeldenummer: PCT/EP2005/008112
(87) Internationale Veröffentlichungsnummer: WO 2006/021280

(56) Entgegenhaltungen:
- EP-A- 0 323 153
- EP-A- 1 182 744
- DE-A1- 10 211 334
- US-A- 3 254 316
- US-A- 5 091 709
- US-A1- 2004 002 232

## Beschreibung

Die vorliegende Erfindung betrifft einen Kalibrierstandard, in Form eines Koaxialkupplers mit Koaxialluftleitung, insbesondere Koaxialstecker oder Koaxialbuchse, zum Anschluss an einen Koaxialkuppler eines zu kalibrierenden Gerätes, insbesondere an ein Messtor eines vektoriellen Netzwerkanalysators (VNA), wobei der Koaxialkuppler ein Innenleiterteil und ein koaxial dazu angeordnetes Außenleiterteil aufweist und eine Kurzschlussverbindung zwischen dem Innenleiterteil und dem Außenleiterteil vorgesehen ist, gemäß dem Oberbegriff des Anspruchs 1.

Die hohe Genauigkeit von vektoriellen Netzwerkanalysatoren (VNA) beruht darauf, dass der Netzwerkanalysator vor der eigentlichen Messung von Betrag und Phase des komplexen Reflexionskoeffizienten durch Anschalten von Kalibrierstandards an seine Messtore kalibriert wird. Zwischenzeitlich gibt es eine Vielzahl von unterschiedlichen Kalibriermethoden. Die meisten Kalibriermethoden benutzen zur Systemkalibrierung Leerlauf-, Kurzschluss- und Anpassungs-Kalibrierstandards. Durch Anschluss dieser Kalibrierstandards an die Messtore des Netzwerkanalysators können die im Netzwerkanalysator entstehenden Fehler, die zu einer Abweichung der Messwerte vom wahren Wert führen, ermittelt und bei der anschließenden Objektmessung zur rechnerischen Fehlerkorrektur benutzt werden. Dies ist beispielsweise aus der DE 39 12 795 A1 bekannt. Aus der EP 0 323 153 A1 ist zudem ein Anpassungs-Kalibrierstandard bekannt, bei dem der Innenleiter relativ zur Referenzebene des Aussenleiters verschoben werden kann um eine höhere Genauigkeit bei der Kalibrierung zu erreichen. Diese bisher üblichen Kalibrier-verfahren sind jedoch immer noch nicht genau genug. Zum Bestimmen der noch verbleibenden restlichen Unsicherheit der Direktivität bzw. der Messtor-Anpassung, wird in einer EA-Richtlinie vorgeschlagen, an dem zu vermessenden Messtor des vorher systemkalibrierten Netzwerkanalysators eine am Ausgang definiert fehlabgeschlossene bzw. kurzgeschlossene Präzisions-Koaxial-Luftleitung anzuschließen und den Reflexionskoeffizienten am Eingang dieser Luftleitung an einer Folge von Messpunkten innerhalb eines vorgegebenen Frequenzbereiches des Netzwerkanalysators zu messen (EA-10/12, EA Guidelines on the Evaluation of Vector Network Analyzers (VNA), European co-operation for Accreditation, May 2000). Nach dieser Richtlinie wird allerdings nur die sog. Ripple-Amplitude der den Betrag des Reflexionskoeffizienten überlagernden Oszillation ausgewertet, wobei vereinfachend angenommen wird, dass diese Ripple-Amplitude in etwa identisch ist mit der effektiven Quelltor-Anpassung, was jedoch nur zutrifft, wenn die effektive Direktivität vernachlässigt wird. Diese bekannte Verifikationsvorschrift unter Verwendung einer Präzisions-Luftleitung ist daher relativ ungenau und ermöglicht keine genaue Abschätzung der zu erwartenden Messunsicherheit geschweige denn eine Nachkorrektur der Fehlerkorrekturterme für die Quelltoranpassung.

In der DE 102 11 334 A1 wurde daher bereits ein Verfahren zum Messen der effektiven Direktivität und/oder der effektiven Quelltor-Anpassung eines Messtores eines systemkalibrierten vektoriellen Netzwerkanalysators vorgeschlagen, wobei eine am Ausgang kurzgeschlossene Präzisions-Luftleitung angeschaltet und der komplexe Reflexionskoeffizient am Eingang dieser Präzisions-Luftleitung an einer Folge von Messpunkten innerhalb eines vorgegebenen Frequenzbereiches gemessen wird. Dabei wird für die effektive Direktivität die Folge der gemessenen komplexen Reflexionskoeffizienten einer diskreten Fourier-Transformation unterworfen und aus dem dadurch gebildeten Spektrum das Basisband ausgefiltert. Durch anschließende inverse Fourier-Rücktransformation wird die Folge von effektiven Direktivitäts-Werten gewonnen.

Der für derartige Messungen erforderliche Kalibrierungsstandard in Form der kurzgeschlossenen Präzisions-Luftleitung ist an den entsprechenden Koaxialkuppler am zu kalibrierenden Gerät angepasst. Koaxialkuppler werden üblicherweise so ausgestaltet, dass diese beim Zusammenstecken mit den jeweiligen Außenleitern aneinander stoßen, bevor die Innenleiter stirnseitig aneinander stoßen, um eine Beschädigung innerhalb des Koaxialkupplers zu vermeiden. Die Kontaktebene zwischen den aneinander stoßenden Außenleitern wird auch als Referenzebene bezeichnet. Bei genau auf Maß gefertigten Koaxialkupplern wäre es aufgrund von Bauteil-Toleranzen möglich, dass die Innenleiter von Stecker und Buchse früher aneinander stoßen als die Außenleiter. Schiebt man dann mit entsprechendem Kraftaufwand Stecker und Buchse weiter ineinander, um auch die Außenleiter stirnseitig aneinander stoßen zu lassen, kommt es zur Beschädigung der Koaxialkuppler im Bereich der jeweiligen Innenleiter. Daher ist es üblich, Stecker und Buchse mit unterschiedlichen Abständen der Stirnfläche des Innenleiterkontaktes von der Außenleiterkontaktebene (Referenzebene) auszugestalten, so dass bei aneinander stoßenden Außenleitern ein Abstand (Versatzmaß) zwischen den Stirnflächen der Innenleiter von Stecker und Buchse verleibt. Ein derartiges Versatzmaß beträgt beispielsweise 2/100 bis 3/100 mm. Dies schützt die Steckverbindung vor Beschädigungen aufgrund von Kräften zwischen den Innenleitern.

Dieses Versatzmaß wirkt sich jedoch bei dem oben erläuterten Kalibrierverfahren auf das Messergebnis in unerwünschter negativ Weise aus bzw. verfälscht die Messwerte in nicht vorhersehbarer Weise und vermindert daher die Genauigkeit. Daher wäre es wünschenswert, einen Kalibrierstandard zur Verfügung zu haben, bei dem das Versatzmaß der Koaxialsteckverbindung zwischen zu kalibrierendem Gerät und angestecktem Kalibrierstandard auf null eingestellt werden kann. Hierzu müsste der Innenleiter des Kalibrierstandards bzgl. des Außenleiters des Kalibrierstandards verschiebbar ausgebildet sein. Insbesondere bei einem Kalibrierstandard in Form der kurzgeschlossenen Präzisions-Luftleitung ist jedoch die Kurzschlussverbindung zwischen Innenleiter und Außenleiter eine potentielle Quelle für Fehler, wenn diese nicht exakt ausgeführt ist. Daher ist bei den bekannten Kalibrierstandards des Typs "Kurzschluss" diese Verbindung fest und unlösbar ausgebildet.

Der Erfindung liegt die Aufgabe zugrunde, einen Kalibrierstandard der o.g. Art bzgl. Einsatzgebiet und Kalibriergenauigkeit zu verbessern.

Diese Aufgabe wird erfindungsgemäß durch einen Kalibrierstandard der o.g. Art mit den in Anspruch 1 gekennzeichneten Merkmalen gelöst. Vorteilhafte Ausgestaltungen der Erfindung sind in den weiteren Ansprüchen beschrieben.

Bei einem Kalibrierstandard der o.g. Art ist es erfindungsgemäß vorgesehen, dass eine Kontakthülse vorgesehen ist, an der das Außenleiterteil und das Innenleiterteil axial zueinander verschiebbar befestigt sind, wobei ein Kontaktmechanismus derart angeordnet und ausgebildet ist, dass dieser wahlweise auf die Kontakthülse einwirkt, so dass die Kontakthülse die Kurzschlussverbindung in Form eines lösbaren elektrischen Kontaktes zwischen dem Innenleiterteil und dem Außenleiterteil herstellt und gleichzeitig das Innenleiterteil und das Außenleiterteil in deren Position relativ zueinander mechanisch festlegt.

Dies hat den Vorteil, dass durch den lösbaren Kurzschluss zwischen Innenleiterteil und Außenleiterteil in Verbindung mit dem Verstellmechanismus für ein exakt einstellbares Versatzmaß zwischen dem Innenleiter und der Referenzebene (Stirnkontaktfläche des Außenleiters) des Koaxialkupplers des Kalibrierstandards ein hoch qualitatives Präzisionsmessmittel zur Verfügung steht, welches an beliebige Versatzmaße zwischen Stirnkontaktflächen von Außenleiter und Innenleiter am Koaxialkuppler des zu kalibrierenden Gerätes anpassbar ist und auch Bauteiltoleranzen in dem Versatzmaß ausgleicht, d.h. es wird ein Spalt zwischen der Stirnkontaktfläche des Innenleiterteiles des Koaxialkupplers des zu kalibrierenden Gerätes und der Stirnkontaktfläche des Innenleiterteiles des Koaxialkupplers des Kalibrierstandard unabhängig von vorbestimmten Abständen des Innenleiters von der Referenzebene und Bauteiltoleranzen minimiert bzw. eliminiert, wodurch ein Messfehler aufgrund der Versatzmaße in den Koaxialkupplern von zu kalibrierendem Gerät und Kalibrierstandard minimiert bzw. eliminiert ist.

In einer bevorzugten Ausführungsform ist die Kontakthülse über einen vorbestimmten axialen Kontaktbereich radial elastisch verformbar mit wenigstens einer Kontaktfläche ausgebildet und mit dem Außenleiterteil unlösbar elektrisch leitend sowie unlösbar mechanisch verbunden, wobei das Innenleiterteil eine Kontaktfläche aufweist, welche bei montiertem Innenleiterteil der wenigstens einen Kontaktfläche im Bereich des radial elastisch verformbaren, axialen Kontaktbereiches der Kontakthülse zugewandt ist, und wobei der Kontaktmechanismus derart angeordnet und ausgebildet ist, dass dieser die Kontakthülse zum Herstellen des elektrischen Kontaktes zwischen dem Innenleiterteil und dem Außenleiterteil wahlweise radial elastisch verformt und die wenigstens eine Kontaktfläche im Bereich des radial elastisch verformbaren, axialen Kontaktbereiches der Kontakthülse mit entsprechender Kontaktkraft gegen die Kontaktfläche des Innenleiterteiles drückt. Die Kontaktfläche am Innenleiterteil ist beispielsweise als Ringbund ausgebildet.

Eine radiale Verformbarkeit des axialen Kontaktbereich erzielt man beispielsweise dadurch, dass die Kontakthülse in dem axialen Kontaktbereich wenigstens zwei in axialer Richtung verlaufende Schlitze aufweist, welche bevorzugt in Umfangsrichtung gleichmäßig voneinander beabstandet sind.

In einer bevorzugten Ausführungsform weist der axiale Kontaktbereich der Kontakthülse im Bereich der wenigstens einen Kontaktfläche des axialen Bereiches der Kontakthülse wenigstens eine sich radial vom Außenumfang der Kontakthülse erhebende, schräge Fläche auf, wobei der Kontaktmechanismus eine Überwurfmutter umfasst, die mittels eines Schraubgewindeeingriffs zwischen einem Außengewinde an der Kontakthülse und einem Innengewinde an der Überwurfmutter mit der Kontakthülse lösbar und in axialer Richtung durch eine Schraubbewegung relativ zur Kontakthülse bewegbar befestigt ist, wobei die Überwurfmutter eine Anschlagfläche aufweist, welche derart angeordnet und ausgebildet ist, dass diese bei Aufschrauben der Überwurfmutter auf die Kontakthülse mit der wenigstens einen schrägen Fläche des axialen Kontaktbereiches der Kontakthülse zusammenwirkend die Kontakthülse in dem axialen Kontaktbereich radial nach innen elastisch verformt und die wenigstens eine Kontaktfläche des axialen Kontaktbereiches der Kontakthülse gegen die Kontaktfläche des Innenleiterteils drückt.

Der axiale Kontaktbereich der Kontakthülse weist beispielsweise wenigstens ein Paar von sich diametral gegenüberliegenden, schrägen Flächen auf, denen ein Paar von dementsprechend gegenüberliegenden Kontaktflächen an einer Innenseite der Kontakthülse zugeordnet ist.

Zweckmäßigerweise sind die schrägen Flächen in Umfangsrichtung gleichmäßig voneinander beabstandet angeordnet.

Zum Minimieren von auf die Kontakthülse wirkenden Torsionskräften und deren Weiterleitung auf das Innenleiterteil während das Aufschraubens und Festziehens der Überwurfmutter ist zwischen der wenigstens einen schrägen Fläche des axialen Kontaktbereiches der Kontakthülse und der Anschlagfläche der Überwurfmutter ein Druckring angeordnet, welcher eine axial gerichtete Kraft der Anschlagfläche der Überwurfmutter auf die wenigstens eine schräge Fläche des axialen Kontaktbereiches der Kontakthülse überträgt.

Einen genau definierten, gleitenden Kontakt in Form eines als Kreislinie in Umfangsrichtung umlaufenden Linienkontaktes zwischen der Innenseite der Druckringes und der wenigstens einen schrägen Fläche des axialen Abschnittes der Kontakthülse erzielt man dadurch, dass eine der wenigstens einen schrägen Fläche des axialen Kontaktabschnittes der Kontakthülse zugewandte Innenfläche des Druckringes mit einer Rundung ausgebildet ist, so dass sich ein Innendurchmesser des Druckringes von einem der Anschlagfläche der Überwurfmutter zugewandten Ende des Druckringes zu einem der wenigstens einen schrägen Fläche des axialen Kontaktbereiches der Kontakthülse zugewandten Ende des Druckringes vergrößert.

Einen mechanisch besonders funktionssicheren und gleichzeitig in Herstellung und Montage kostengünstigen Aufbau erzielt man dadurch, dass das Außenleiterteil und das Innenleiterteil an einem Innenumfang der Klemmhülse an dieser befestigt sind.

Beispielsweise ist die Befestigung zwischen der Kontakthülse und dem Innenleiterteil als Schraubeingriff zwischen einem Außengewinde am Innenleiterteil und einem Innengewinde an der Kontakthülse ausgebildet.

Dadurch, dass das Innengewinde an der Kontakthülse im Bereich des geschlitzten axialen Kontaktbereiches der Kontakthülse ausgebildet ist, ergibt sich eine mechanische Befestigung bei festgezogener Überwurfmutter nicht nur im Bereich der aneinander gedrückten Kontaktflächen von Innenleiterteil und Kontakthülse, sondern zusätzlich durch einen mechanischen Reibschluss im Bereich des Schraubgewindeeingriffes zwischen dem Innenleiterteil und der Kontakthülse. Hierdurch die die mechanische und elektrische Verbindung zwischen dem Innenleiterteil und der Kontakthülse getrennt, so dass die Kurzschlussverbindung zwischen dem Außenleiterteil und dem Innenleiterteil über die Kontakthülse frei von sich ggf. ändernden mechanischen Belastungen ist, was eine Güte bzw. Genauigkeit der Kurzschlussverbindung beeinträchtigen würde.

Die Erfindung wird im Folgenden anhand der Zeichnung näher erläutert. Diese zeigt in:
- Fig. 1: eine bevorzugte Ausführungsform eines erfindungsgemäßen Kalibrier- standards in Form einer Koaxialbuchse in perspektivischer Ansicht,
- Fig. 2: den Kalibrierstandard gemäß Fig. 1 in Schnittansicht,
- Fig. 3: eine bevorzugte Ausführungsform eines erfindungsgemäßen Kalibrier- standards in Form eines Koaxialsteckers in perspektivischer Ansicht,
- Fig. 4: den Kalibrierstandard gemäß Fig. 3 in Schnittansicht,
- Fig. 5: eine Überwurfmutter für einen Kalibrierstandard gemäß Fig. 1 oder 3 in perspektivischer Ansicht,
- Fig. 6: die Überwurfmutter gemäß Fig. 5 in teilweise geschnittener Seiteansicht,
- Fig. 7: einen Druckring für einen Kalibrierstandard gemäß Fig. 1 oder 3 in per- spektivischer Ansicht,
- Fig. 8: den Druckring gemäß Fig. 7 in Schnittansicht,
- Fig. 9: eine Kontakthülse für einen Kalibrierstandard gemäß Fig. 1 oder 3 in per- spektivischer Ansicht und
- Fig. 10: die Kontakthülse gemäß Fig. 9 in teilweise geschnittener Seiteansicht.

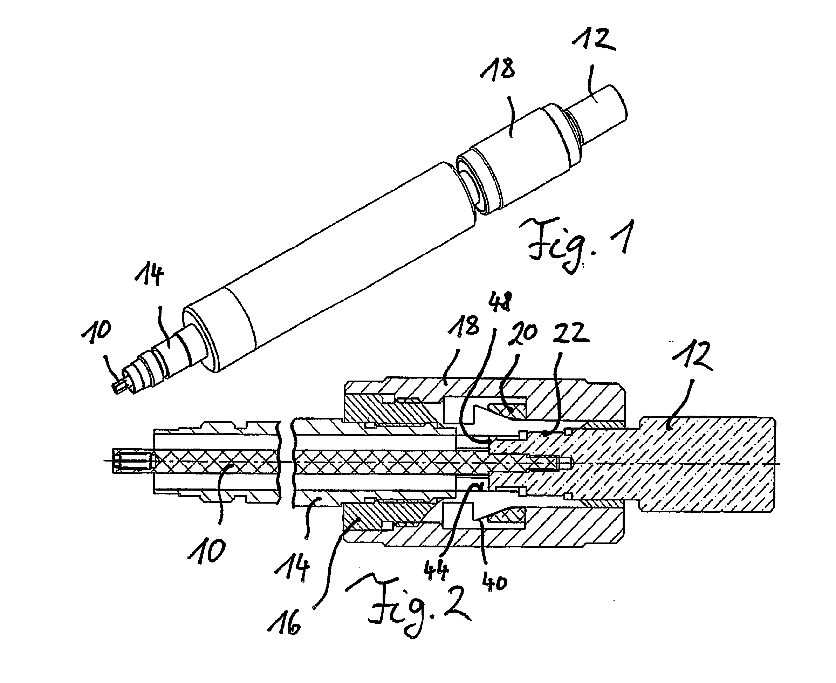

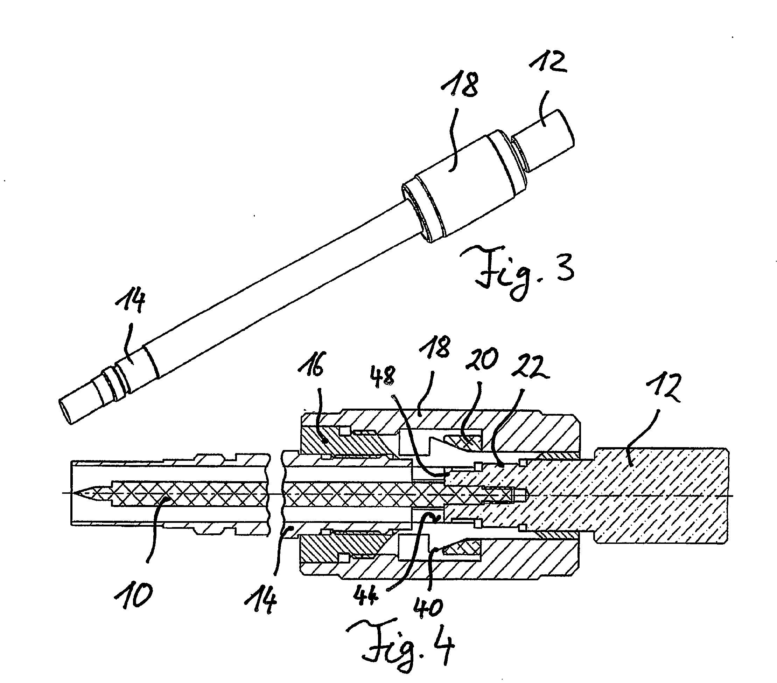

In den Fig. 1 bis 4 ist eine bevorzugte Ausführungsform eines erfindungsgemäßen Kalibrierstandards als Koaxialbuchse (Fig. 1 und 2) bzw. Koaxialstecker (Fig. 3 und 4) dargestellt, welcher auch als "Offset-Short" bezeichnet wird und, wie insbesondere aus Fig. 2 und 4 ersichtlich, folgendes umfasst: Ein Innenleiterteil 10 mit Stellschraube 12, ein Außenleiterteil 14, eine Kontakthülse 16, eine Feststellschraube bzw. Feststell- bzw. Überwurfmutter 18 und einen Druckring 20. Das Außenleiterteil 14 und die Kontakthülse 16 bilden eine feste Einheit. Ebenso bilden das Innenleiterteil 10 und die Stellschraube 12 eine feste Einheit, wobei in der dargestellten Ausführungsform Innenleiterteil 10 und Stellschraube 12 miteinander verschraubt sind. Das Innenleiterteil 10 ist bei 22 mittels eines Schraubgewindeeingriffs (in der Schnittdarstellung von Fig. 2 und 4 nicht sichtbar) zwischen einem Außengewinde an der Stellschraube 12 und einem Innengewinde an der Kontakthülse 16 mit der Kontakthülse 16 verbunden, wobei durch Drehen der Stellschraube 12 das Innenleiterteil 10 relativ zum Außenleiterteil 14 axial bewegbar ist. Dadurch kann ein Versatzmaß, d.h. ein Abstand zwischen der Stirnfläche des Innenleiterteils und einer Stirnfläche des Außenleiterteils (Referenzebene), stufenlos eingestellt werden.

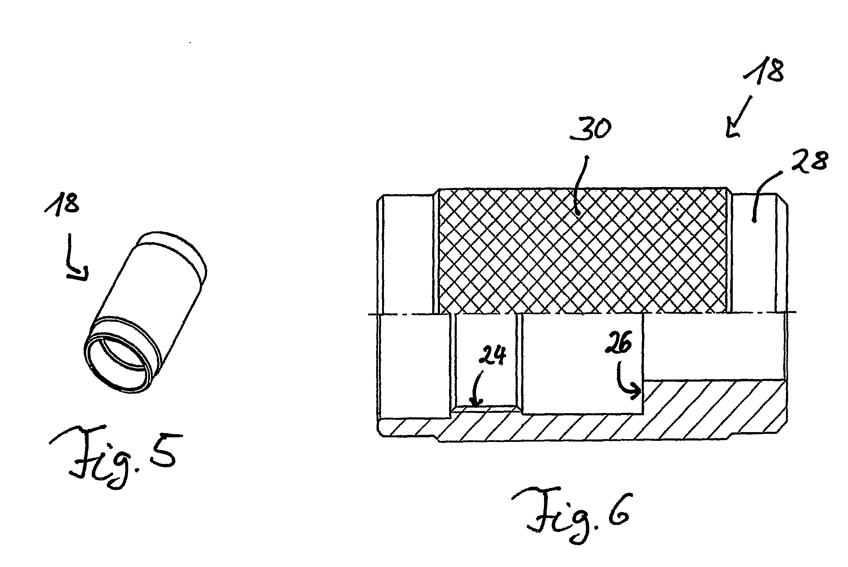

Wie aus Fig. 5 und 6 ersichtlich, umfasst die Feststell- oder Überwurfmutter 18 ein Innengwinde 24 und eine Anschlagfläche 26 auf, welche ringförmig, in Umfangsrichtung umlaufend und in axialer Richtung ausgerichtet ausgebildet ist. An einer Außenseite 28 ist die Feststell- oder Überwurfmutter 18 mit einer geriffelten Oberfläche 30 ausgebildet, welche eine manuelle, drehende Betätigung der Feststell-oder Überwurfmutter 18 durch einen Benutzer vereinfacht bzw. unterstützt.

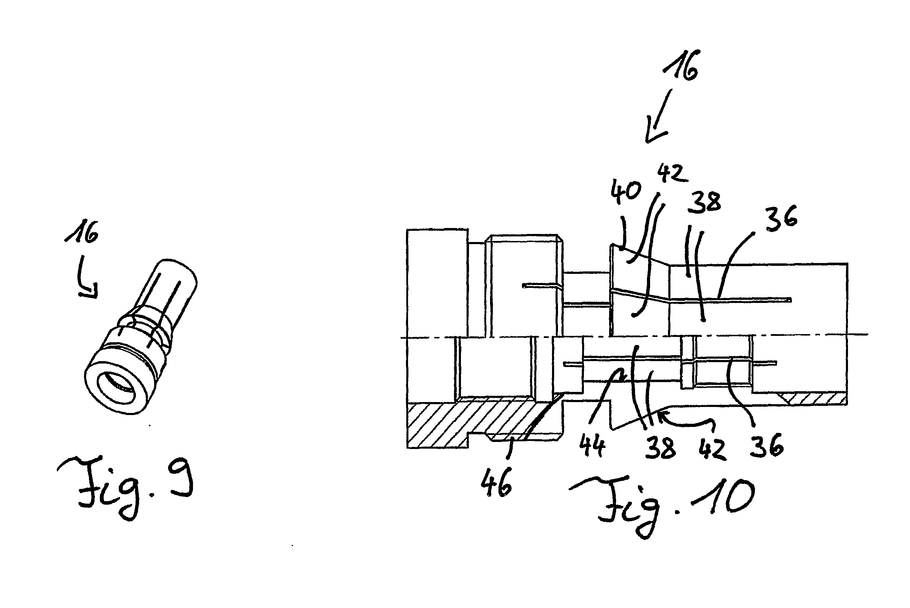

Wie aus Fig. 9 und 10 ersichtlich, weist die Kontakthülse 16 einen axialen Kontaktbereich auf, der mit mehreren in axialer Richtung verlaufenden, in Umfangsrichtung gleichmäßig voneinander beabstandeten Schlitzen 36 ausgestattet ist. Durch diese Schlitze 36 sind im axialen Kontaktbereich der Kontakthülse 16 voneinander getrennte Segmente 38 ausgebildet, welche in radialer Richtung elastisch auslenkbar sind. In dem geschlitzten axialen Kontaktbereich der Kontakthülse 16 ist ferner ein sich radial konisch erweiternder Abschnitt 40 angeordnet, der in jedem Segment 38 an der Außenseite der Kontakthülse 16 eine schräge Fläche 42 ausbildet, wobei an der Innenseite der Kontakthülse 16 gegenüber einer jeden schrägen Fläche 42 eine Kontaktfläche 44 an jedem Segment 38 vorgesehen ist. Weiterhin weist die Kontakthülse 16 an deren Außenumfang ein Außengewinde 46 auf. Das zuvor erwähnte und wegen der Art der Schnittdarstellung nicht sichtbare Innengewinde der Kontakthülse 16 ist für den Eingriff des Außengewindes der Stellschraube 12 im Bereich des geschlitzten axialen Kontaktbereiches der Kontakthülse ausgebildet.

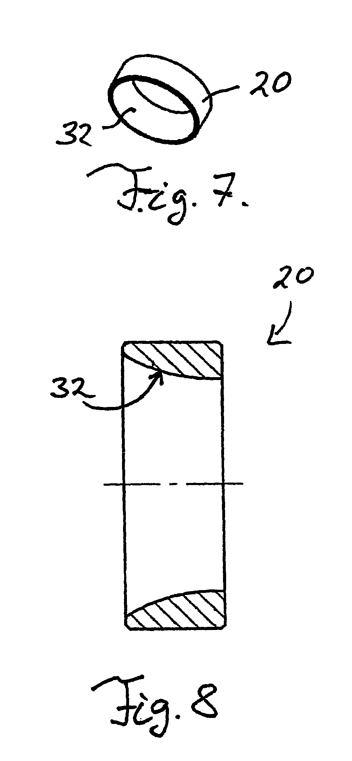

Wie aus Fig. 7 und 8 ersichtlich, ist eine Innenfläche 32 des Druckringes 20, dessen Funktion nachfolgend näher beschrieben wird, mit einer Rundung ausgebildet, so dass sich ein Innendurchmesser des Druckringes 20 über dessen axialer Erstreckung verändert. Der Druckring 20 ist zwischen den schrägen Flächen 42 des sich radial konisch erweiternden Abschnittes 40 der Kontakthülse 16 und der Anschlagfläche 26 der Feststell- bzw. Überwurfmutter 18 derart angeordnet, dass die Innenfläche 32 des Druckringes 20 an den schrägen Flächen 42 anliegt. Durch die gerundete Ausbildung der Innenfläche 32 des Druckringes 20 ergibt sich eine in Umfangsrichtung umlaufende, gleitende Kontaktlinie in Form einer wegen der Schlitze 36 unterbrochenen Kreislinie zwischen der Innenfläche 32 des Druckringes 20 und den schrägen Flächen 42.

Die Feststell- bzw. Überwurfmutter 18 ist mittels eines Schraubgewindeeingriffs zwischen dem Innengewinde 24 der Feststell- bzw. Überwurfmutter 18 und dem Außengewinde 46 der Kontakthülse 16 an dieser befestigt. Durch Aufschrauben der Feststell- bzw. Überwurfmutter 18 auf dieses Außengewinde 46 der Kontakthülse 16 bewegt sich die Feststell- bzw. Überwurfmutter 18 in axialer Richtung relativ zur Kontakthülse 16, so dass sich ein axialer Abstand zwischen den schrägen Flächen 42 des sich radial konisch erweiternden Abschnittes 40 der Kontakthülse 16 und der Anschlagfläche 26 der Feststell- bzw. Überwurfmutter 18 verringert, so dass die Anschlagfläche 26 der Feststell- bzw. Überwurfmutter 18 den Druckring 20 axial auf die schrägen Flächen 42 schiebt. Dadurch wird über die gleitende Kontaktlinie zwischen schrägen Flächen 42 und der Innenfläche 32 des Druckringes 20 eine in axialer Richtung gerichtete Kraft auf die schrägen Flächen 42 ausgeübt, die diese ihrerseits wegen der Schräge in eine radial nach innen gerichtete, auf die Segmente 38 wirkende Kraft umlenken. Durch diese Kraft werden die Segmente 38 mit zunehmendem Aufschrauben der Feststell- bzw. Überwurfmutter 18 immer weiter radial nach innen gedrückt und dementsprechend radial elastisch ausgelenkt.

Das Innenleiterteil 10 weist im Bereich der Kontaktflächen 44, welche an der Innenseite der Kontakthülse 16 radial nach innen gerichtet ausgebildet sind, einen Ringbund 48 auf, welcher an seinem Außenumfang eine radial nach außen gerichtete, in Umfangsrichtung umlaufende Kontaktfläche für einen Kurzschlusskontakt zwischen Außenleiterteil 14 und Innenleiterteil 10 ausbildet. Mit zunehmender radialer Auslenkung der Segmente 38 beim Aufschrauben der Feststell- bzw. Überwurfmutter 18 auf das Außengewinde 46 der Kontakthülse 16 werden die Kontaktflächen 44 an der Innenseite der Kontakthülse 16 gegen die Kontaktfläche des Ringbundes 48 gedrückt. Hierdurch ergibt sich ein elektrischer Kontakt zwischen dem Innenleiterteil 10 und der Kontakthülse 16 mit entsprechendem Kontaktdruck und entsprechender Kontaktfläche. Der Kontaktdruck wird dabei von der aufgeschraubten Feststell- bzw. Überwurfmutter 18 erzeugt bzw. aufrechterhalten. Da die Kontakthülse 16 andererseits fest mit dem Außenleiterteil 14 elektrisch und mechanisch verbunden ist, ergibt sich über die Kontakthülse 16 ein elektrischer Kurzschluss zwischen Außenleiterteil 14 und Innenleiterteil 10 bei dem Ringbund 48. Der elektrische Kurzschluss ist durch die erfindungsgemäße Anordnung funktionssicher und in ausreichender Qualität wiederholbar herstellbar.

Die radiale Auslenkung der Segmente 38 bedingt auch eine entsprechende Verformung des im Bereich dieser Segmente 38 ausgebildeten Innengewindes der Kontakthülse 16 zum Eingriff für das Außengewinde der Stellschraube 12. Hierdurch wird bei Auslenkung der Segmente 38 zusätzlich zum elektrischen Kurzschlusskontakt der Schraubgewindeeingriff zwischen Stellschraube 12 und Kontakthülse 16 blockiert, wodurch im Bereich dieses Gewindes eine mechanisch feste Verbindung zwischen Kontakthülse 16 und Stellschraube 12 bzw. Innenleiterteil 10 hergestellt wird. Diese mechanische Verbindung ist örtlich getrennt vom elektrischen Kurzschlusskontakt im Bereich des Ringbundes 48.

In den Fig. 2, 4 und 10 verläuft die Schnittebene genau durch einen Schlitz 36 der Kontakthülse 16, so dass sich in den Schnittdarstellungen jeweils eine schraffierte Schnittfläche nur an den axialen Enden der Kontakthülse 16 ergibt.

Eine Kalibrierung mit dem erfindungsgemäßen Kalibrierstandard läuft beispielsweise wie folgt ab: Bestimmen des Versatzmaßes zwischen Stirnfläche des Innenleiterteils und Referenzebene (Stirnfläche des Außenleiterteils) am Steckinterface (Koaxialstecker oder Koaxialbuchse) des zu kalibrierenden Gerätes. Anschließen einer Versatzmaßuhr an das Steckinterface (Koaxialstecker oder Koaxialbuchse) des Kalibrierstandards. Drehen der Stellschraube 12 bis das gewünschte Versatzmaß am Koaxialkuppler des Kalibrierstandards eingestellt ist bzw. bis die Versatzmaßuhr dieses gewünschte Versatzmaß anzeigt. Drehen der Feststell- bzw. Überwurfmutter 18, bis durch den axialen Vorschub dieser der Druckring 20 die Kontaktflächen 44 der Segmente 38 über die schrägen Flächen 42 radial gegen die Kontaktfläche des Ringbundes 48 des Innenleiterteils 10 drückt. Dies stellt eine exakte Kurzschlussverbindung zwischen dem Innenleiterteil 10 und dem Außenleiterteil 14 über die Kontakthülse 16 her und schafft, wie zuvor erwähnt, eine mechanisch feste Verbindung zwischen Kontakthülse 16 und Stellschraube 12 bzw. Innenleiterteil 10. Außerdem sind jetzt alle Einzelteile 10, 14 16 und 18 fest miteinander mechanisch verbunden.

Der erfindungsgemäße Kalibrierstandard bietet eine einfache Handhabung des Einstellmechanismus mit stufenloser Einstellmöglichkeit auf ein beliebiges Versatzmaß. Durch den Ausgleich des Versatzmaßes am Steckinterface des zu kalibrierenden Gerätes sind Messfehler vermieden, die durch Innenleiterspalte entstehen können. Es gibt nur eine Steckverbindung zwischen Messtor des zu kalibrierenden Gerätes und dem Messobjekt, d.h. dem Kalibrierstandard. Es ist kein zusätzliches Stützelement für den Innenleiter in Form eines Dielektrikums erforderlich, da die Kontakthülse 16 diese Stützfunktion übernimmt. Das Funktionsprinzip kann auf beliebige Koaxialquerschnitte übertragen werden. Das Innenleiterteil 10 ist dreifach geführt, nämlich in der Kurzschlussebene zum Außenleiter, durch die Gewindeverbindung zwischen der Einstellschraube und der Kontakthülse 16 sowie über den Druck, den die Feststell- bzw. Überwurfmutter 18 auf den Ringbund 48 ausübt. Der Druckring 20 ist ein loses Einzelbauteil mit leichter Rundung an der Innenseite 32. Dadurch gibt es einen genau definierten, gleitenden Kontakt auf der geschlitzten Schräge 40, 42 der Kontakthülse 16. Eine gerade Ausführung der Innenseite 32 wäre wegen einer einschneidenden Kontaktkante oder eines eventuell flächenhaften Kontaktes ungünstiger. Weiterhin bewirkt diese lose, gleitende Verbindung zwischen Konus 40 und Feststell- bzw. Überwurfmutter 18 folgendes: Bis zum exakten Anzug der Feststell- bzw. Überwurfmutter 18 minimiert der gleitende Druckring 20 die Torsionskräfte auf den Konus 40 und damit eine weitere Übertragung auf das Innenleiterteil 10. Bei einer festen Einheit von Druckring 20 und Feststell- bzw. Überwurfmutter 18 wäre dies nicht gewährleistet. Der Kalibrierstandard kann schnell und einfach in alle Einzelteile zerlegt werden. Dies ermöglicht in vorteilhafter Weise ein Vermessen des Leitungsdurchmessers über die gesamte Leitungslänge und gewährleistet somit eine Rückführbarkeit auf elektrische Messergebnisse. Wartung und Reparatur sind ebenfalls erleichtert.

## Patentansprüche

1. Kalibrierstandard, in Form eines Koaxialkupplers mit Koaxialluftleitung, insbesondere Koaxialstecker oder Koaxialbuchse, zum Anschluss an einen Koaxialkuppler eines zu kalibrierenden Gerätes, insbesondere an ein Messtor eines vektoriellen Netzwerkanalysators (VNA), wobei der Koaxialkuppler ein Innenleiterteil (10) und ein koaxial dazu angeordnetes Außenleiterteil (14) aufweist und eine Kurzschlussverbindung zwischen dem Innenleiterteil und dem Außenleiterteil vorgesehen ist,
wobei
eine Kontakthülse (16) vorgesehen ist, an der das Außenleiterteil (14) und das Innenleiterteil (10) axial zueinander verschiebbar befestigt sind, wobei ein Kontaktmechanismus (18) derart angeordnet und ausgebildet ist, dass bei Einwirkung des Kontaktmechanismus (18) auf die Kontakthülse (16), die Kontakthülse (16) die Kurzschlussverbindung in Form eines lösbaren elektrischen Kontaktes (44, 48) zwischen dem Innenleiterteil (10) und dem Außenleiterteil (14) herstellt und gleichzeitig das Innenleiterteil (10) und das Außenleiterteil (14) in deren Position relativ zueinander mechanisch festlegt.

2. Kalibrierstandard nach Anspruch 1, **dadurch gekennzeichnet, dass** die Kontakthülse (16) über einen vorbestimmten axialen Kontaktbereich radial elastisch verformbar mit wenigstens einer Kontaktfläche (44) ausgebildet und mit dem Außenleiterteil (14) unlösbar elektrisch leitend sowie unlösbar mechanisch verbunden ist, wobei das Innenleiterteil (10) eine Kontaktfläche aufweist, welche bei montiertem Innenleiterteil der wenigstens einen Kontaktfläche (44) im Bereich des radial elastisch verformbaren, axialen Kontaktbereiches der Kontakthülse (16) zugewandt ist, und wobei der Kontaktmechanismus (18) derart angeordnet und ausgebildet ist, dass dieser die Kontakthülse (16) zum Herstellen des elektrischen Kontaktes zwischen dem Innenleiterteil (10) und dem Außenleiterteil (14) radial elastisch verformt und die wenigstens eine Kontaktfläche (44) im Bereich des radial elastisch verformbaren, axialen Kontaktbereiches der Kontakthülse (16) mit entsprechender Kontaktkraft gegen die Kontaktfläche (48) des Innenleiterteiles (10) drückt.

3. Kalibrierstandard nach Anspruch 2, **dadurch gekennzeichnet, dass** die Kontaktfläche am Innenleiterteil als Ringbund (48) ausgebildet ist.

4. Kalibrierstandard nach Anspruch 2 oder 3, **dadurch gekennzeichnet, dass** die Kontakthülse (16) in dem axialen Kontaktbereich wenigstens zwei in axialer Richtung verlaufende Schlitze (36) aufweist.

5. Kalibrierstandard nach Anspruch 4, **dadurch gekennzeichnet, dass** die Schlitze (36) in Umfangsrichtung gleichmäßig voneinander beabstandet sind.

6. Kalibrierstandard nach wenigstens einem der Ansprüche 2 bis 5, **dadurch gekennzeichnet, dass** der axiale Kontaktbereich der Kontakthülse (16) im Bereich der wenigstens einen Kontaktfläche (44) des axialen Bereiches der Kontakthülse (16) wenigstens eine sich radial vom Außenumfang der Kontakthülse (16) erhebende, schräge Fläche (42) aufweist, wobei der Kontaktmechanismus eine Überwurfmutter (18) umfasst, die mittels eines Schraubgewindeeingriffs zwischen einem Außengewinde (46) an der Kontakthülse (16) und einem Innengewinde (24) an der Überwurfmutter (18) mit der Kontakthülse (16) lösbar und in axialer Richtung durch eine Schraubbewegung relativ zur Kontakthülse (16) bewegbar befestigt ist, wobei die Überwurfmutter (18) eine Anschlagfläche (26) aufweist, welche derart angeordnet und ausgebildet ist, dass diese bei Aufschrauben der Überwurfmutter (18) auf die Kontakthülse (16) mit der wenigstens einen schrägen Fläche (42) des axialen Kontaktbereiches der Kontakthülse (16) zusammenwirkend die Kontakthülse (16) in dem axialen Kontaktbereich radial nach innen elastisch verformt und die wenigstens eine Kontaktfläche (44) des axialen Kontaktbereiches der Kontakthülse (16) gegen die Kontaktfläche (48) des Innenleiterteils (10) drückt.

7. Kalibrierstandard nach Anspruch 6, **dadurch gekennzeichnet, dass** der axiale Kontaktbereich der Kontakthülse (16) wenigstens ein Paar von sich diametral gegenüberliegenden, schrägen Flächen (42) aufweist, denen ein Paar von dementsprechend gegenüberliegenden Kontaktflächen (44) an einer Innenseite der Kontakthülse (16) zugeordnet ist.

8. Kalibrierstandard nach Anspruch 6 oder 7, **dadurch gekennzeichnet, dass** die schrägen Flächen (42) in Umfangsrichtung gleichmäßig voneinander beabstandet angeordnet sind.

9. Kalibrierstandard nach wenigstens einem der Ansprüche 6 bis 9, **dadurch gekennzeichnet, dass** zwischen der wenigstens einen schrägen Fläche (42) des axialen Kontaktbereiches der Kontakthülse (16) und der Anschlagfläche (26) der Überwurfmutter (18) ein Druckring (20) angeordnet ist, welcher eine axial gerichtete Kraft der Anschlagfläche (26) der Überwurfmutter (18) auf die wenigstens eine schräge Fläche (42) des axialen Kontaktbereiches der Kontakthülse (16) überträgt.

10. Kalibrierstandard nach Anspruch 9, **dadurch gekennzeichnet, dass** eine der wenigstens einen schrägen Fläche (42) des axialen Kontaktabschnittes der Kontakthülse (16) zugewandte Innenfläche (32) des Druckringes (20) mit einer Rundung ausgebildet ist, so dass sich ein Innendurchmesser des Druckringes (20) von einem der Anschlagfläche (26) der Überwurfmutter (18) zugewandten Ende des Druckringes (20) zu einem der wenigstens einen schrägen Fläche (42) des axialen Kontaktbereiches der Kontakthülse (16) zugewandten Ende des Druckringes (20) vergrößert.

11. Kalibrierstandard nach wenigstens einem der vorhergehenden Ansprüche, **dadurch gekennzeichnet, dass** das Außenleiterteil (14) und das Innenleiterteil (10) an einem Innenumfang der Kontakthülse (16) an dieser befestigt sind.

12. Kalibrierstandard nach wenigstens einem der vorhergehenden Ansprüche, **dadurch gekennzeichnet, dass** die Befestigung zwischen der Kontakthülse (16) und dem Innenleiterteil (10) als Schraubeingriff zwischen einem Außengewinde am Innenleiterteil (10) und einem Innengewinde an der Kontakthülse (16) ausgebildet ist.

13. Kalibrierstandard nach Anspruch 12 und wenigstens einem der Anspruche 4 und 5, **dadurch gekennzeichnet, dass** das Innengewinde an der Kontakthülse (16) im Bereich des geschlitzten axialen Kontaktbereiches der Kontakthülse (16) ausgebildet ist.

## Claims

1. Calibration standard in the form of a coaxial coupling comprising a coaxial airline, in particular a coaxial plug or coaxial socket for connecting to a coaxial coupling of a device to be calibrated, in particular a measuring port of a vectorial network analyser (VNA), wherein the coaxial coupling has an inner conductor part (10) and an outer conductor part (14) arranged coaxially therewith and a short-circuit connection is provided between the inner conductor part and the outer conductor part, wherein a contact coupling sleeve (16) is provided on which the outer conductor part (14) and the inner conductor part (10) are fixed axially displaceable relative to one another, wherein a contact mechanism (18) is arranged and configured such that when said contact mechanism (18) acts on the contact coupling sleeve (16), said contact coupling sleeve (16) creates the short-circuit connection in the form of a breakable electrical contact (44, 48) between the inner conductor part (10) and the outer conductor part (14) and simultaneously mechanically fixes the inner conductor part (10) and the outer conductor part (14) in their position relative to one another.

2. Calibration standard according to claim 1, **characterised in that** the contact coupling sleeve (16) is radially elastically deformable over a predetermined axial contact region and is configured with at least one contact surface (44) and is in undetachable electrically conductive and mechanical connection with the outer conductor part (14), wherein the inner conductor part (10) has a contact surface which, with the inner conductor part mounted, faces toward the at least one contact surface (44) in the region of the radially elastically deformable axial contact region of the contact coupling sleeve (16), and wherein the contact mechanism (18) is arranged and configured such that it radially elastically deforms the contact coupling sleeve (16) to create the electrical contact between the inner conductor part (10) and the outer conductor part (14) and the at least one contact surface (44) presses with corresponding contact force against the contact surface (48) of the inner conductor part (10) in the region of the radially elastically deformable axial contact region of the contact coupling sleeve (16).

3. Calibration standard according to claim 2, **characterised in that** the contact surface is formed on the inner conductor part as an annular collar (48).

4. Calibration standard according to claim 2 or 3, **characterised in that** the contact coupling sleeve (16) has at least two slits (36) which extend in the axial direction in the axial contact region.

5. Calibration standard according to claim 4, **characterised in that** the slits (36) are equally spaced from one another in the peripheral direction.

6. Calibration standard according to at least one of the claims 2 to 5, **characterised in that** the axial contact region of the contact coupling sleeve (16) has, in the region of the at least one contact surface (44) of the axial region of the contact coupling sleeve (16), at least one inclined surface (42) projecting radially from the outer periphery of the contact coupling sleeve (16), wherein the contact mechanism comprises a coupling ring (18) which is detachably fastened, by means of a screw thread engagement between an external thread (46) on the contact coupling sleeve (16) and an internal thread (24) on the coupling ring (18), to the contact coupling sleeve (16) and is movable in the axial direction relative to the contact coupling sleeve (16) by means of a screw movement, wherein the coupling ring (18) has a stop surface (26) which is arranged and configured such that, on screwing the coupling ring (18) onto the contact coupling sleeve (16), said stop surface (26) in cooperation with the at least one inclined surface (42) of the axial contact region of the contact coupling sleeve (16) elastically deforms the contact coupling sleeve (16) radially inwardly in the axial contact region and presses the at least one contact surface (44) of the axial contact region of the contact coupling sleeve (16) against the contact surface (48) of the inner conductor part (10).

7. Calibration standard according to claim 6, **characterised in that** the axial contact region of the contact coupling sleeve (16) has at least one pair of mutually diametrically opposed inclined surfaces (42) to which are assigned a pair of correspondingly opposed contact surfaces (44) on an inner side of the contact coupling sleeve (16).

8. Calibration standard according to claim 6 or 7, **characterised in that** the inclined surfaces (42) are equally spaced from one another in the peripheral direction.

9. Calibration standard according to at least one of the claims 6 to 9, **characterised in that** arranged between the at least one inclined surface (42) of the axial contact region of the contact coupling sleeve (16) and the stop surface (26) of the coupling ring (18) is a compression ring (20) which transmits an axially directed force of the stop surface (26) of the coupling ring (18) to the at least one inclined surface (42) of the axial contact region of the contact coupling sleeve (16).

10. Calibration standard according to claim 9, **characterised in that** an internal surface (32) of the compression ring (20) facing toward the at least one inclined surface (42) of the axial contact region of the contact coupling sleeve (16) is configured with a rounding such that an internal diameter of the compression ring (20) increases in size from an end of the compression ring (20) facing toward the stop surface (26) of the coupling ring (18) to an end of the compression ring (20) facing toward the at least one inclined surface (42) of the axial contact region of the contact coupling sleeve (16).

11. Calibration standard according to one of the preceding claims, **characterised in that** the outer conductor part (14) and the inner conductor part (10) are fastened to the contact coupling sleeve (16) at an internal periphery of said contact coupling sleeve (16).

12. Calibration standard according to at least one of the preceding claims, **characterised in that** the fastening between the contact coupling sleeve (16) and the inner conductor part (10) is configured as a screw engagement between an external thread on the inner conductor part (10) and an internal thread on the contact coupling sleeve (16).

13. Calibration standard according to claim 12 and at least one of the claims 4 and 5, **characterised in that** the internal thread on the contact coupling sleeve (16) is configured in the region of the slit axial contact region of the contact coupling sleeve (16).

## Revendications

1. Étalon de calibrage, sous la forme d'un coupleur coaxial avec conduit d'air coaxial, en particulier fiche mâle coaxiale ou fiche femelle coaxiale, destiné au raccordement à un coupleur coaxial d'un appareil à calibrer, en particulier à un port de mesure d'un analyseur de réseau vectoriel (VNA), le coupleur coaxial comprenant une partie de conducteur intérieure (10) et une partie de conducteur extérieure (14) agencée coaxialement à celle-ci, et une liaison de court-circuit entre la partie de conducteur intérieure et la partie de conducteur extérieure, dans lequel il est prévu une douille de contact (16) sur laquelle la partie de conducteur extérieure (14) et la partie de conducteur intérieure (10) sont fixées avec possibilité de translation axiale l'une par rapport à l'autre, et dans lequel un mécanisme de contact (18) est agencé et réalisé de telle manière que, sous l'action du mécanisme de contact (18) sur la douille de contact (16), la douille de contact (16) établit la liaison à court-circuit sous la forme d'un contact électrique (44, 48) susceptible d'être annulé entre la partie de conducteur intérieure (10) et la partie de conducteur extérieure (14) et immobilise simultanément la partie de conducteur intérieure (10) et la partie de conducteur extérieure (14) mécaniquement dans leurs positions l'une par rapport à l'autre.

2. Étalon de calibrage selon la revendication 1, **caractérisé en ce que** la douille de contact (16) est élastiquement déformable radialement sur une zone de contact axiale prédéterminée et réalisée avec au moins une surface de contact (44), et raccordée à la fois de manière à conduire l'électricité et de manière mécanique avec la partie de conducteur extérieure (14) sans pouvoir être détachée, la partie de conducteur intérieure (10) présentant une surface de contact qui, lorsque la partie de conducteur intérieure est montrée, est tournée vers ladite au moins une surface de contact (44) dans la région de la zone de contact axiale élastiquement déformable radialement, de la douille de contact (16), et dans lequel le mécanisme de contact (18) est agencé et réalisé de telle façon que celui-ci déforme la douille de contact (16) élastiquement radialement pour établir le contact électrique entre la partie de conducteur intérieure (10) et la partie de conducteur extérieure (14), et pousse ladite au moins une surface de contact (44), dans la région de la zone de contact axiale élastiquement déformable radialement, de la douille de contact (16), avec une force de contact correspondante contre la surface de contact (48) de la partie de conducteur intérieure (10).

3. Étalon de calibrage selon la revendication 2, **caractérisé en ce que** la surface de contact est réalisée sur la partie de conducteur intérieure sous la forme d'une collerette annulaire (48).

4. Étalon de calibrage selon la revendication 2 ou 3, **caractérisé en ce que** la douille de contact (16) comporte, dans la zone de contact axiale, au moins deux fentes (36) qui s'étendent en direction axiale.

5. Étalon de calibrage selon la revendication 4, **caractérisé en ce que** les fentes (36) sont régulièrement écartées les unes des autres en direction périphérique.

6. Étalon de calibrage selon l'une au moins des revendications 2 à 5, **caractérisé en ce que** la zone de contact axiale de la douille de contact (16) présente, dans la zone de ladite au moins une surface de contact (44) de la région axiale de la douille de contact (16), au moins une surface oblique (42) qui se dresse radialement depuis la périphérie extérieure de la douille de contact (16), le mécanisme de contact comprenant un écrou-raccord (18) qui est fixé, au moyen d'un engagement vissé entre un filetage (46) sur la douille de contact (16) et un taraudage (24) sur l'écrou-raccord (18), à la douille de contact (18) de façon détachable, et mobile en direction axiale grâce à un mouvement de vissage par rapport à la douille de contact (16), dans lequel l'écrou-raccord (18) comporte une surface de butée (26), laquelle est agencée et réalisée de telle façon que celle-ci, lors du vissage de l'écrou-raccord (18) sur la douille de contact (16), déforme la douille de contact (16) élastiquement radialement vers l'intérieur dans la zone de contact axiale par coopération avec ladite au moins une surface oblique (42) de la zone de contact axiale de la douille de contact (16), et pousse ladite au moins une surface de contact (44) de la zone de contact axiale de la douille de contact (16) contre la surface de contact (48) de la partie de conducteur intérieure (10).

7. Étalon de calibrage selon la revendication 6, **caractérisé en ce que** la zone de contact axiale de la douille de contact (16) comprend au moins une paire de surfaces obliques (42) diamétralement opposées, auxquelles sont associées une paire de surfaces de contact (44) opposées de façon correspondante sur une face intérieure de la douille de contact (16).

8. Étalon de calibrage selon la revendication 6 ou 7, **caractérisé en ce que** les surfaces obliques (42) sont agencées régulièrement écartées les unes des autres en direction périphérique.

9. Étalon de calibrage selon l'une au moins des revendications 6 à 9, **caractérisé en ce qu'**une bague de pressage (20) est agencée entre ladite au moins une surface oblique (42) de la zone de contact axiale de la douille de contact (16) et la surface de butée (26) de l'écrou-raccord (18), ladite bague de pressage transmettant une force orientée axialement de la surface de butée (26) de l'écrou-raccord (18) vers ladite au moins une surface oblique (42) de la zone de contact axiale de la douille de contact (16).

10. Étalon de calibrage selon la revendication 9, **caractérisé en ce qu'**une surface intérieure (32), tournée vers ladite au moins une surface oblique (42) de la zone de contact axiale de la douille de contact (16), de la bague de pressage (20), est réalisée avec un arrondi, de sorte qu'un diamètre intérieur de la bague de pressage (20) augmente depuis une extrémité de la bague de pressage (20) tournée vers la surface de butée (26) de l'écrou-raccord (18) vers une extrémité de la bague de pressage (20) tournée vers la zone de contact axiale de la douille de contact (16).

11. Étalon de calibrage selon l'une au moins des revendications précédentes, **caractérisé en ce que** la partie de conducteur extérieure (14) et la partie de conducteur intérieure (10) sont fixées sur la douille de contact (16) au niveau d'une périphérie intérieure de celle-ci.

12. Étalon de calibrage selon l'une au moins des revendications précédentes, **caractérisé en ce que** la fixation entre la douille de contact (16) et la partie de conducteur intérieure (10) est réalisé sous forme d'un engagement vissé entre un filetage sur la partie de conducteur intérieure (10) et un taraudage sur la douille de contact (16).

13. Étalon de calibrage selon la revendication 12 et l'une au moins des revendications 4 et 5, **caractérisé en ce que** le taraudage est réalisé dans la douille de contact (16) dans la région de la zone de contact axiale fendue de la douille de contact (16).
